# EUROPÄISCHE PATENTSCHRIFT

(11) **EP 2 089 643 B1**
(45) Veröffentlichungstag und Bekanntmachung des Hinweises auf die Patenterteilung: **31.12.2014**
(21) Anmeldenummer: 07820742.0
(22) Anmeldetag: 01.10.2007
(51) Int. Cl.: F16J 9/26, C23C 14/06, C23C 16/34, C23C 30/00

(54) **KOLBENRING FÜR VERBRENNUNGSKRAFTMASCHINEN**
PISTON RING FOR INTERNAL COMBUSTION ENGINES
SEGMENT DE PISTON POUR MOTEURS À COMBUSTION INTERNE

(30) Priorität: 04.10.2006 DE 102006046917
(43) Veröffentlichungstag der Anmeldung: 19.08.2009
(73) Patentinhaber: Federal-Mogul Burscheid GmbH, 51399 Burscheid (DE)
(72) Erfinder: FISCHER, Manfred, 42799 Leichlingen (DE); LAMMERS, Ralf, 42929 Wermelskirchen (DE); BAUER, Christiane, 51399 Burscheid (DE); HOPPE, Steffen, 51491 Overath (DE)
(74) Vertreter: Mehler Achler
(86) Internationale Anmeldenummer: PCT/EP2007/060356
(87) Internationale Veröffentlichungsnummer: WO 2008/040694

(56) Entgegenhaltungen:
- JP-A- 2005 060 810
- ULRICH S ET AL: "Correlation between constitution, properties and machining performance of TiN/ZrN multilayers" SURFACE AND COATINGS TECHNOLOGY, ELSEVIER, AMSTERDAM, NL, Bd. 188-189, 1. November 2004 (2004-11-01), Seiten 331-337, XP004622229 ISSN: 0257-8972
- DUCROS ET AL: "Multilayered and nanolayered hard nitride thin films deposited by cathodic arc evaporation. Part 1: Deposition, morphology and microstructure" SURFACE AND COATINGS TECHNOLOGY, ELSEVIER, AMSTERDAM, NL, Bd. 201, Nr. 1-2, 12. September 2006 (2006-09-12), Seiten 136-142, XP005561272 ISSN: 0257-8972

## Beschreibung

Die Erfindung betrifft einen Kolbenring aus einem Trägermaterial, insbesondere aus Stahl oder einem Gusswerkstoff, mit einer Verschleißschutzbeschichtung aus einem periodisch aufgebauten Viellagenschichtsystem, wobei jede Periodizität aus mindestens zwei Einzellagen aus Metallnitriden besteht.

Die Laufflächen von Kolbenringen in Verbrennungskraftmaschinen unterliegen während ihres Einsatzes einem Verschleiß. Um den Verschleiß zu minimieren, werden die Laufflächen der Kolbenringe mit einer Schutzschicht versehen.

Aus der JP 2005-082822 AA und JP 2005-187859 AA ist ein Trägermaterial mit einem Viellagenschichtsystem bekannt, das Metallnitridschichten aufweist. Hinweise auf unterschiedliche metallische Elemente in den Einzellagen aus Metallnitriden finden sich in beiden Vorveröffentlichungen nicht.

Die DE 44 41 136 A1 offenbart einen Druckring für einen Kolben einer Kolbenzylinderanordnung einer Kolbenbrennkraftmaschine. Die abriebfeste Beschichtung besteht aus einem Nitrid, wie CrN, Cr₂N, TiN, Ti/TiN oder ZrN. Die Beschichtung besteht lediglich aus einer einzigen Schicht. Hinweise auf ein Viellagenschichtsystem sind der DE 44 41 136 A1 nicht zu entnehmen.

Die JP 2002-256967 AA offenbart ein Gleitelement mit einer abriebfesten Beschichtung. Als Beispiel wird ein Kolbenring erwähnt, der eine Schicht auf Basis von Metallnitriden aufweist. Auch in dieser Vorveröffentlichung finden sich keine Hinweise auf Viellagenschichtsysteme.

Aus der DE 100 61 749 A1 ist eine Verschleißschutzbeschichtung für Kolbenringe in Verbrennungskraftmaschinen bekannt, die im Wesentlichen aus Chromcarbiden, Chrom, Nickel und Molybdän besteht. Ein aus diesen Komponenten bestehendes Pulver wird mittels Hochgeschwindigkeitsflammspritzen auf die Kolbenringe aufgebracht. Obwohl solche Schutzschichten hinsichtlich des Verschleißes gute Ergebnisse zeigten, ist die Rissbeständigkeit, insbesondere unter hohen Belastungen, wie sie in den neuartigen Dieselmotoren auftritt, nicht zufrieden stellend.

Aus dem Bereich hochbelasteter Werkzeuge, wie z. B. Schneidwerkzeuge, ist es seit langem bekannt, Viellagenschichtsysteme als Schutzschicht vorzusehen. Aus der DE 35 12 986 C2 ist eine Verschleißschutzbeschichtung bekannt, deren Einzellagendicken im Bereich von 0,5 bis 40 nm liegen. Soweit als Einzellage eine TiN-Schicht verwendet wird, so wird diese mit einer weiteren Einzellage aus einem Carbid oder einem Borid kombiniert.

Diese Viellagenschichttechnologie hat auch Eingang in die Herstellung von Kolbenringen gefunden. Aus der JP 2005-060810 A sind Kolbenringe für Verbrennungskraftmaschinen bekannt, die mit einem Viellagenschichtsystem versehen sind, deren Einzellagen dieselbe metallische Komponente aufweisen und sich lediglich im Stickstoffgehalt unterscheiden. Die Schichtdicken der Einzellagen werden mit < 1 µm angegeben. Die Schichten werden mittels eines PVD-Verfahrens, insbesondere eines Lichtbogenverfahrens, aufgebracht.

Die DE 10 2004 028 486 A1 beschreibt ein Gleitbauteil, wie z. B. Kolbenringe für Verbrennungsmotoren, das eine Beschichtung aus mehreren Einzellagen aufweist, die abwechselnd aus Chrom und Chromnitrid bestehen. Die Chromnitridschichten können aus CrN, Cr2N oder Mischungen hieraus bestehen. Zur Vermeidung schroffer Übergänge wird das Beschichtungsverfahren so gesteuert, dass die Chromnitrideinzellagen jeweils beiderseits einen Saum aus Cr2N und einen Kern aus CrN aufweisen. Jede Einzellage ist mindestens 0,01 µm dick. Die maximale Dicke beträgt 10 µm. Die Gesamtdicke der Beschichtung wird mit 5 bis 100 µm angegeben.

Diese bekannten Viellagenschichtsysteme haben jedoch den Nachteil, dass die Rissbeständigkeit nicht zufrieden stellend ist.

Aus "Correlation between constitution, properties and machining performance of TiN/ZrN multilayers" von S. Ulrich et al. sind Viellagenschichtsysteme aus Titannitrid und Zirkonnitrid bekannt, die eine Säulenmorphologie aufweisen, um Hohlräume zur Aufnahme von Kühlmitteln auszubilden. Dieses Schichtsystem wird für Schneidwerkzeuge eingesetzt.

Aufgabe der Erfindung ist es daher, einen Kolbenring mit einem Vellagenschichtsystem zu versehen, das bei guter Verschleißbeständigkeit weniger rissanfällig ist.

Diese Aufgabe wird mit einem Kolbenring gelöst, bei dem benachbarte Einzellagen innerhalb einer Periodizität unterschiedliche metallische Elemente aufweisen und die Dicke einer Einzellage ≥ 15 nm beträgt.

Es hat sich herausgestellt, dass ein Viellagenschichtsystem aus Metall-Nitridschichten einerseits eine gute Verschleißbeständigkeit aufweist und andererseits durch die Verwendung unterschiedlicher Metalle für die benachbarten Einzellagen innerhalb der Periodizität eine geringe Rissanfälligkeit besitzt. Durch die Verwendung unterschiedlicher Metalle für die Metallnitride der Einzellagen können die Härte- und die Elastizitätseigenschaften der Einzellagen so aufeinander abgestimmt werden, dass deutliche Phasengrenzen auftreten. Wenn - wie im Stand der Technik beschrieben - nur ein Metall eingesetzt wird und lediglich der Stickstoffgehalt variiert wird, bilden sich keine so deutlichen Phasengrenzen aus, dass diese einen positiven Einfluss auf die Rissbildung ausüben könnten.

Es hat sich gezeigt, dass Risse, sofern sie überhaupt auftreten, nur bis zur jeweils nächsten Phasengrenze laufen. Derartige Risse können allenfalls zur partiellen Ablösung von Teilen einer Einzellage führen. Die Ablösung des gesamten Viellagenschichtsystems aufgrund von Rissbildung wird nicht beobachtet.

Die Lebensdauer von Kolbenringen mit einem derartigen Viellagenschichtsystem ist deutlich höher als bei Kolbenringen mit einer herkömmlichen Einzellage oder mit einem Viellagenschichtsystem, das zwar ebenfalls aus Nitridschichten besteht, in denen aber lediglich der Stickstoffgehalt bei gleicher metallischer Komponente verändert wird.

Vorzugsweise weisen die Einzellagen Nitride mindestens eines Metalls aus der Gruppe Titan (Ti), Zirkonium (Zr), Hafnium (Hf), Vanadium (V), Niob (Nb), Tantal (Ta), Chrom (Cr), Molybdän (Mo) und Wolfram (W) auf.

Grundsätzlich sind alle Kombinationen von Nitriden der genannten Metalle möglich. Dabei kann es sich um stöchiometrische Phasen oder um nicht stöchiometrische Phasen oder Mischungen daraus handeln. Zum Beispiel soll unter CrN eine oder mehrere Phasen aus dem System Cr-N verstanden werden, analog gilt das für die anderen Systeme. Je nach Beschichtungsverfahren kann eventuell die eine oder andere Kombination bevorzugt sein.

Besonders bevorzugt ist die Verwendung von CrN für mindestens eine Einzellage der Periodizität. CrN kann im Viellagenschichtsystem mit den Nitriden aller anderen Metalle der genannten Gruppe kombiniert werden.

Bevorzugte Einzellagenkombinationen sind CrN/TiN, CrN/ZrN oder CrN/VN.

Die Periodizität kann auch mehr als zwei Einzellagen, vorzugsweise bis zu vier Einzellagen, aufweisen. Zwei Einzellagen sind insofern bevorzugt, weil der Herstellungsaufwand mit zunehmender Einzellagenanzahl pro Periodizität deutlich zunimmt.

Vorzugsweise enthält mindestens eine Einzellage der Periodizität > 0 bis 15 Gew.%, insbesondere 3 bis 8 Gew.%, mindestens eines der Dotierelemente Aluminium, Silicium oder Kohlenstoff. Diese Dotierelemente bewirken, dass die Verschleißschutzschichten höhere Oxidationsbeständigkeiten und geringere Reibwerte aufweisen.

Vorzugsweise sind die Dotierelemente benachbarter Einzellagen unterschiedlich. Die Unterschiede in den Eigenschaften der benachbarten Einzellagen werden durch die Zugabe der Dotierelemente zusätzlich vergrößert mit der Folge, dass die Unterschiede in den Materialeigenschaften der benachbarten Einzellagen an den Phasengrenzen noch deutlicher zutage treten, was sich besonders günstig auf die Verhinderung der Rissausbreitung senkrecht zu den Einzellagen auswirkt.

Es ist auch möglich, dass mindestens eine der Einzellagen der Periodizität Nitride aus mindestens zwei Metallen aus der Gruppe Ti, Zr, Hf, V, Nb, Ta, Cr, Mo und W enthält, wobei benachbarte Einzellagen sich in mindestens einem metallischen Element unterscheiden.

Bevorzugte Metallkombinationen der Nitride für mindestens eine Einzellage der Periodizität sind TiZrN, TiAlN, CrSiN, CrZrN, CrTiN oder CrVN. Die genannten Metallkombinationen können auch die genannten Dotierelemente aufweisen. Die Vorteile dieser Metallkombinationen für die Einzellagen bestehen darin, dass die jeweiligen Materialeigenschaften variiert und angepasst werden können.

Nach einer Periodizität oder mehreren Periodizitäten kann mindestens eine Zwischenlage aus mindestens einem der Metalle Ti, Zr, Hf, V, Nb, Ta, Cr, Mo, W vorgesehen sein. Die Vorteile dieser Zwischenlagen bestehen darin, dass sie als duktile Metalle in der Lage sind, die Rissausbreitung umzulenken bzw. zu stoppen und die Gesamtduktilität des Viellagenverbandes deutlich zu erhöhen, so dass die Gesamteigenspannungen reduziert werden können. Dies ist wichtig insbesondere für die Abscheidung von Verschleißschutzschichten, die zur Erhöhung der Lebensdauer mit höherer Schichtdicke abgeschieden werden.

Vorzugsweise ist zwischen dem Trägermaterial und der ersten Einzellage mindestens eine Haftschicht vorgesehen, die aus mindestens einem der Metalle Ti, Zr, Hf, V, Nb, Ta, Cr, Mo und W bestehen kann.

Ein Vorteil besteht darin, dass die ansonsten übliche Nitrierung der Oberfläche des Trägermaterials, insbesondere des Stahls, entfallen kann, wodurch ein Arbeitsschritt eingespart wird.

Diese Einsparung wird zusätzlich verstärkt, wenn das Haftschichtmaterial mit dem Material der Zwischenlage oder mit dem Metall einer Einzellage identisch ist. Das Abscheideverfahren muss dann lediglich über die Zusammensetzung des Prozeßgases modifiziert werden.

Bevorzugte Haftschichtmaterialien sind Chrom und Titan, insbesondere bei Trägerwerkstoffen aus Stahl, weil sie eine besonders gute Haftung auf Stahlwerkstoffen aufweisen.

Die Dicke einer Periodizität beträgt vorzugsweise 30 nm bis 1µm, bevorzugt 30 nm bis 500 nm, besonders bevorzugt 30 nm bis 120 nm und besonders bevorzugt 60 nm bis 120 nm. Vorzugsweise liegt die Untergrenze der Periodizität der genannten Wertebereiche bei >30 nm.

Es hat sich gezeigt, dass sich bezüglich der Verschleißbeständigkeit für jede Materialkombination der Einzellagen ein optimaler Wert für die Periodizität ergibt.

Die Dicke einer Einzellage beträgt vorzugsweise 15 nm bis 150 nm.

Die Dicke des Viellagenschichtsystems beträgt vorzugsweise 10 µm bis 50 µm, insbesondere 10 µm bis 30 µm. Diese Dicken liegen unterhalb der Dicken, die für Schichten nach dem Stand der Technik, z. B. für eine einlagige Chromnitridschicht benötigt werden, um dieselbe Einsatzdauer zu gewährleisten. Durch die Dickenverringerung der Verschleißschutzbeschichtung wird Material und Zeit bei der Herstellung der Beschichtung eingespart.

Vorzugsweise ist das Viellagenschichtsystem mittels eines PVD-Verfahrens aufgebracht.

Mittels der PVD-Verfahren lassen sich besonders günstig die Metallnitride TiN, ZrN, VN, CrN und MoN auftragen.

Als bevorzugtes Verfahren ist das Lichtbogenverfahren vorgesehen, um das Viellagenschichtsystem aufzubringen.

Das Viellagenschichtsystem kann auch mittels eines CVD-Verfahrens aufgebracht werden.

Die besondere Verwendung solcher erfindungsgemäßer Kolbenringe ist für Dieselmotoren und Ottomotoren vorgesehen.

Die Verschleißschutzbeschichtung ist insbesondere für Kompressionsringe und für Ölringe geeignet.

Beispielhafte Ausführungsformen der Erfindung werden nachfolgend anhand der Zeichnungen näher erläutert.

Es zeigen:
- Figur 1: einen Kolbenring in perspektivischer Darstellung,
- Figur 2: einen Schnitt längs der Linie II-II durch den in Figur 1 gezeigten Kolbenring,
- Figur 3: eine vergrößerte Darstellung der Einzelheit X aus Figur 2,
- Figur 4: eine vergrößerte Darstellung der Einzelheit Y aus Figur 3,
- Figur 5a: eine rasterelektronenmikroskopische Aufnahme eines Viellagenschichtsystems aus Einzellagen aus CrN/ZrN,
- Figur 5b: eine rasterelektronenmikroskopische Aufnahme eines Viellagenschichtsystems aus Einzellagen aus CrN/TiN,
- Figur 6: eine schematische Darstellung eines Viellagenschichtsystems gemäß einer weiteren Ausführungsform.

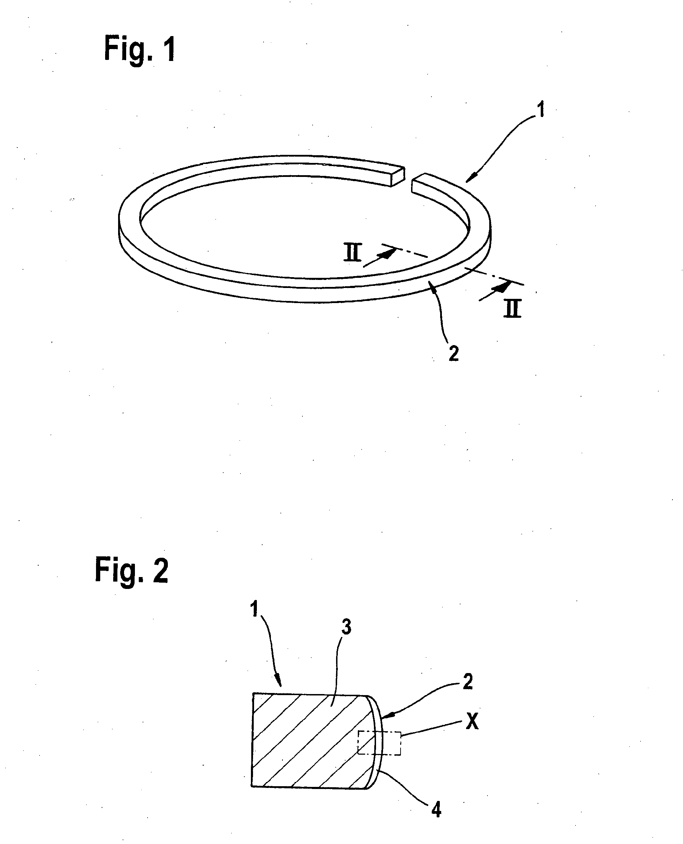

In der Figur 1 ist ein Kolbenring 1 perspektivisch dargestellt. Die Außenumfangsfläche bildet die Lauffläche 2.

In der Figur 2 ist ein Schnitt längs der Linie II-II durch den in Figur 1 gezeigten Kolbenring 1 dargestellt. Die Lauffläche 2 hat eine leicht ballige Form. Die auf dem Trägermaterial 3 abgeschiedene Verschleißschutzbeschichtung 4 bildet diese ballige Form ab.

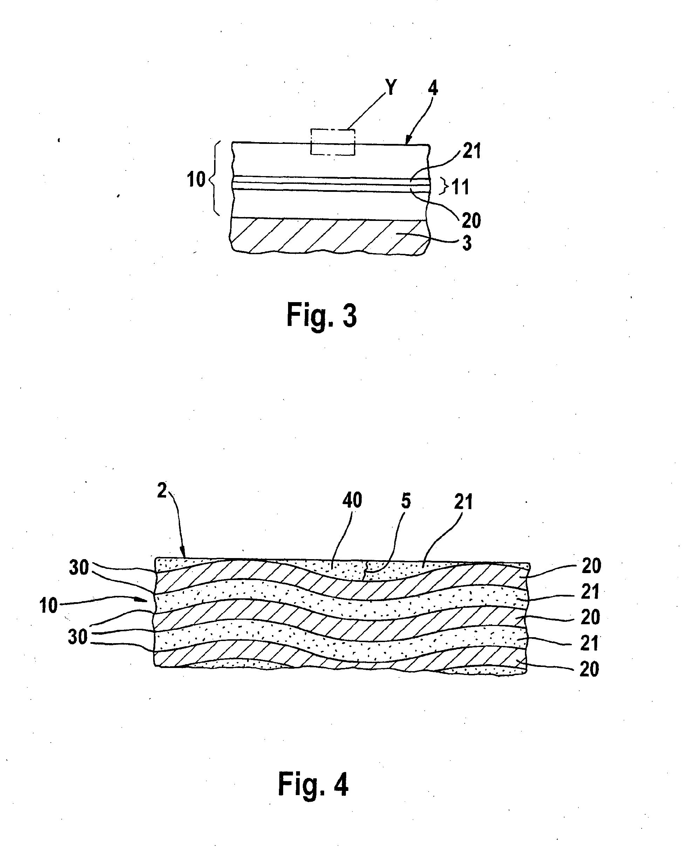

In der Figur 3 ist eine vergrößerte Darstellung der Einzelheit X aus der Figur 2 dargestellt. Auf dem Trägermaterial 3 befindet sich das Viellagenschichtsystem 10, das aus einer Vielzahl von Periodizitäten 11 gebildet wird. Jede Periodizität 11 besteht aus zwei Einzellagen 20, 21, wobei der Übersichtlichkeit halber lediglich eine Periodizität 11 eingezeichnet ist.

In der Figur 4 ist eine Vergrößerung der Einzelheit Y aus Figur 3 dargestellt. Aufgrund unweigerlich vorhandener Unebenheiten auf der Oberfläche des Trägermaterials 3 bildet sich eine mehr oder weniger ausgeprägte Wellenform für die Einzellagen aus, wobei diese durch die mechanische Nachbearbeitung an der Oberfläche geglättet wird.

In der Figur 4 ist in der Oberflächenschicht 21 ein Riss 5 eingezeichnet, der sich von der Oberfläche ins Innere erstreckt. Dieser Riss 5 endet an der ersten Phasengrenze 30. Ein weiteres Vordringen des Risses 5 ins Innere des Viellagenschichtsystems wird durch diese Phasengrenze 30 verhindert. Je deutlicher die Unterschiede der Materialeigenschaften zwischen den Einzellagen 20 und 21 sind, desto definierter werden die Risse abgelenkt.

Wenn sich weitere Risse in der Einzellage 21 innerhalb des inselförmigen Bereiches 40 ausbilden, kann der Fall eintreten, dass dieser Bereich 40 abblättert. Ein weiteres Ablösen der darunter liegenden Einzellage 20 findet jedoch nicht statt. Die Lebensdauer dieser Beschichtung und damit des Kolbenrings 1 wird aufgrund des Viellagenschichtsystems 10 deutlich erhöht, weil Risse sich immer nur bis zur nächsten Phasengrenze ausbreiten können.

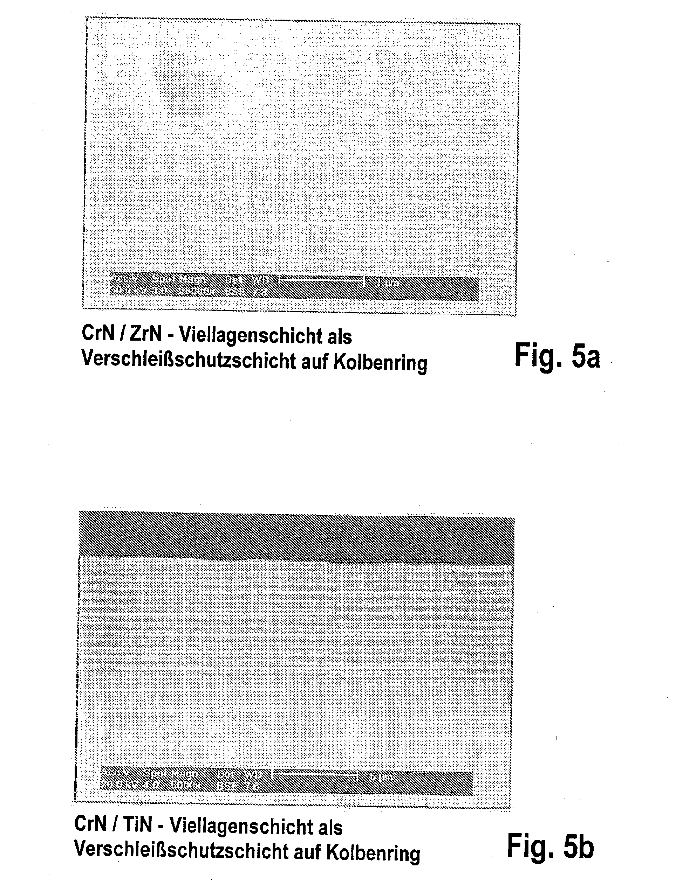

In der Figur 5a ist eine rasterelektronenmikroskopische Aufnahme dargestellt, bei der die Einzellagen aus CrN und ZrN bestehen.

Die Figur 5b zeigt eine rasterelektronenmikroskopische Aufnahme, bei der die Einzellagen aus CrN und TiN bestehen.

In der nachfolgenden Tabelle 1 sind die bevorzugten Metalle der Metallnitride in einer Matrix dargestellt. Alle Metallnitridkombinationen für die benachbarten Einzellagen sind mit der Ausnahme der Identität erfindungsgemäß vorgesehen. Die besonders bevorzugten Metallnitridkombinationen sind durch X gekennzeichnet.

**Tabelle 1 (Metalle der Metallnitride)**

| System Nr. | | Ti | Zr | Hf | V | Nb | Ta | Cr | Mo | W |
|---|---|---|---|---|---|---|---|---|---|---|
| 1 | Ti | | X | X | X | X | X | X | X | X |
| 2 | Zr | X | | X | X | X | X | X | X | X |
| 3 | Hf | X | X | | X | | | X | | |
| 4 | V | X | X | X | | X | X | X | X | X |
| 5 | Nb | X | X | | X | | | X | | |
| 6 | Ta | X | X | | X | | | X | | |
| 7 | Cr | X | X | X | X | X | X | | X | X |
| 8 | Mo | X | X | | X | | | X | | |
| 9 | W | X | X | | X | | | X | | |

Die System-Nummer 7, wonach immer eine CrN-Schicht als Einzellage innerhalb der Periodizität beteiligt ist, ist durch eine besonders gute Stabilität des Viellagenschichtsystems ausgezeichnet. Die System-Nummern 1, 2 und 4 bezeichnen Metallnitridkombinationen, die sich besonders günstig im Lichtbogenverfahren abscheiden lassen.

### Beispiel:

Auf Kolbenringen wurden zum Verschleißschutz in einem reaktiven Lichtbogenverfahren Viellagenschichten (mit einer Haftschicht aus Chrom) abgeschieden. Es handelte sich dabei um nitrierte Kolbenringe aus einem hochlegierten Stahl. Die Verschleißschutzschichten bestanden aus den Einzellagen CrN und ZrN, die periodisch abgeschieden wurden. Die Gesamtschichtdicken betrugen 12 µm bis 12,8 µm. Es wurden drei unterschiedliche Periodizitäten realisiert.

In der Tabelle 2 sind die Gesamtschichtdicken, Periodizitäten und Schichthärten aufgelistet. Zur Überprüfung der Verschleißbeständigkeit wurden mit diesen Kolbenringen Modellversuche mit geschmierter, reversierender Gleitbeanspruchung durchgeführt. Der Gegenkörper bestand jeweils aus einem Zylinderlaufbahnsegment aus Guss (GOE 300, Werkstoff der Anmelderin), als Schmierstoff wurde zur Zeitraffung ein synthetischer Ester ohne Additive eingesetzt.

Durch die geeignete Wahl der Periodizität der Viellagenschichten können sowohl der Verschleiß der Schicht und des Gegenkörpers als auch der Reibwert optimiert werden.

**Tabelle 2**

| Schicht | Dicke µm | Periodizität | Schichthärte | Verschleiß der Schicht | Verschleiß des Gegenkörpers | Reibwert |
|---|---|---|---|---|---|---|
| CrN/ZrN | 12,5 | 233 nm | 2108 HV 0,1 | 3 µm | 59 µm | 0,085 |
| CrN/ZrN | 12 | 67 nm | 2231 HV 0,1 | 1 µm | 42,5 µm | 0,055 |
| CrN/ZrN | 12,8 | 107 nm | 2151 HV 0,1 | 0 µm | 33,5 µm | 0,050 |

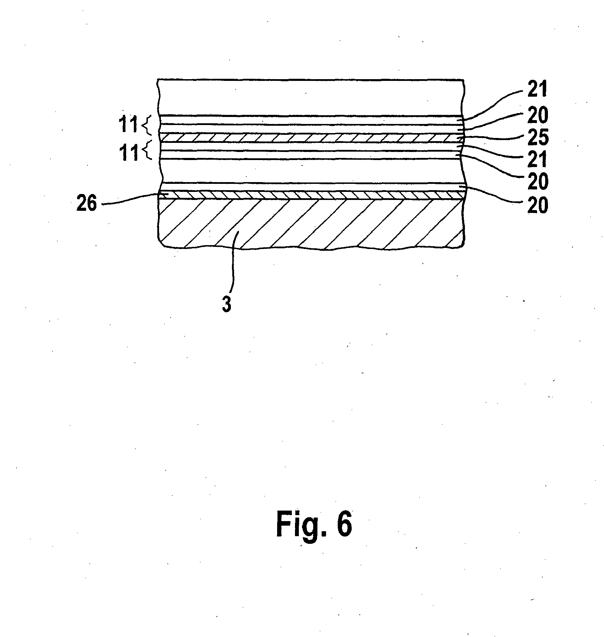

In der Figur 6 ist schematisch ein Viellagenschichtsystem 10 gemäß einer weiteren Ausführungsform dargestellt. Zwischen den Periodizitäten 11 ist jeweils eine Zwischenlage 25 vorgesehen. Außerdem ist zwischen der ersten Einzellage und dem Trägermaterial eine Haftschicht 26 vorgesehen. Es ist auch möglich, nur eine Haftschicht oder nur Zwischenlagen vorzusehen.

### Bezugszeichenliste

- 1: Kolbenring
- 2: Lauffläche
- 3: Trägermaterial
- 4: Verschleißschutzbeschichtung
- 5: Riss

- 10: Viellagenschichtsystem
- 11: Periodizität

- 20: Einzellage
- 21: Einzellage
- 25: Zwischenlage
- 26: Haftschicht

- 30: Phasengrenze

- 40: inselförmiger Bereich

## Patentansprüche

1. Kolbenring (1) aus einem Trägermaterial (3), insbesondere aus Stahl oder einem Gusswerkstoff, und mit einer Verschleißschutzbeschichtung (4) aus einem periodisch aufgebauten Viellagenschichtsystem (10), wobei jede Periodizität (11) aus mindestens zwei Einzellagen (20, 21) aus Metallnitriden besteht, **dadurch gekennzeichnet, dass** benachbarte Einzellagen (20, 21) innerhalb einer Periodizität (11) unterschiedliche metallische Elemente aufweisen und dass die Dicke einer Einzellage (20, 21) ≥15 nm beträgt.

2. Kolbenring nach Anspruch 1, **dadurch gekennzeichnet, dass** die Einzellagen (20, 21) Nitride mindestens eines Metalls aus der Gruppe Ti, Zr, Hf, V, Nb, Ta, Cr, Mo und W aufweisen.

3. Kolbenring nach Anspruch 1 oder 2, **dadurch gekennzeichnet, dass** mindestens eine Einzellage (20, 21) der Periodizität (11) aus CrN besteht.

4. Kolbenring nach einem der Ansprüche 1 bis 3, **dadurch gekennzeichnet, dass** jede Periodizität (11) aus zwei Einzellagen (20, 21) aus CrN und TiN (CrN/TiN), CrN und ZrN (CrN/ZrN) oder CrN und VN (CrN/VN) besteht.

5. Kolbenring nach einem der Ansprüche 1 bis 4, **dadurch gekennzeichnet, dass** mindestens eine der Einzellagen (20, 21) der Periodizität > 0 bis 15 Gew.% mindestens eines der Dotierelemente Aluminium, Silicium oder Kohlenstoff enthält.

6. Kolbenring nach Anspruch 5, **dadurch gekennzeichnet, dass** die Dotierelemente benachbarter Einzellagen (20, 21) unterschiedlich sind.

7. Kolbenring nach einem der Ansprüche 1 bis 6, **dadurch gekennzeichnet, dass** mindestens eine der Einzellagen (20, 21) der Periodizität Nitride aus mindestens zwei Metallen aus der Gruppe Ti, Zr, Hf, V, Nb, Ta, Cr, Mo und W enthält, wobei benachbarte Einzellagen (20, 21) sich in mindestens einem metallischen Element unterscheiden.

8. Kolbenring nach Anspruch 7, **dadurch gekennzeichnet, dass** mindestens eine Einzellage (20, 21) der Periodizität aus TiZrN, TiAlN, CrSiN, CrZrN, CrTiN oder CrVN besteht.

9. Kolbenring nach einem der Ansprüche 1 bis 8, **dadurch gekennzeichnet, dass** nach einer oder mehreren Periodizitäten (11) mindestens eine Zwischenlage (25) aus mindestens einem der Metalle Ti, Zr, Hf, V, Nb, Ta, Cr, Mo und W vorgesehen ist.

10. Kolbenring nach einem der Ansprüche 1 bis 9, **dadurch gekennzeichnet, dass** zwischen dem Trägermaterial (3) und der Verschleißschutzschicht (4) mindestens eine Haftschicht (26) vorgesehen ist.

11. Kolbenring nach Anspruch 10, **dadurch gekennzeichnet, dass** die Haftschicht (26) aus mindestens einem der Metalle Ti, Zr, Hf, V, Nb, Ta, Cr, Mo und W besteht.

12. Kolbenring nach einem der Ansprüche 1 bis 11, **dadurch gekennzeichnet, dass** die Dicke einer Periodizität (11) 30 nm bis 1 µm, bevorzugt 30 nm bis 500 nm, besonders bevorzugt 30 bis 120 nm und besonders bevorzugt 60 nm bis 120 nm beträgt.

13. Kolbenring nach einem der Ansprüche 1 bis 12, **dadurch gekennzeichnet, dass** die Dicke einer Einzellage bevorzugt 15 nm bis 150 nm beträgt.

14. Kolbenring nach einem der Ansprüche 1 bis 13, **dadurch gekennzeichnet, dass** die Dicke des Viellagenschichtsystems (10) 10 µm bis 50 µm, bevorzugt 10 µm bis 30 µm beträgt.

15. Verwendung eines Kolbenrings nach Anspruch 1 in Dieselmotoren oder Ottomotoren.

## Claims

1. Piston ring (1) comprising a carrier material (3), in particular of steel or a cast material, and having a wear protection coating (4) of a periodically constructed multi-layer coating system (10), each periodicity (11) consists of at least two individual layers (20, 21) of metal nitrides, **characterised in that** adjacent individual layers (20, 21) have different metallic elements within a periodicity (11) and **in that** the thickness of an individual layer (20, 21) is ≥ 15 nm.

2. Piston ring according to claim 1, **characterised in that** the individual layers (20, 21) have nitrides of at least one metal from the group Ti, Zr, Hf, V, Nb, Ta, Cr, Mo and W.

3. Piston ring according to claim 1 or claim 2, **characterised in that** at least one individual layer (20, 21) of the periodicity (11) consists of CrN.

4. Piston ring according to any one of claims 1 to 3, **characterised in that** each periodicity (11) consists of two individual layers (20, 21) of CrN and TiN (CrN/TiN), CrN and ZrN (CrN/ZrN) or CrN and VN (CrN/VN).

5. Piston ring according to any one of claims 1 to 4, **characterised in that** at least one of the individual layers (20, 21) of the periodicity contains > 0 to 15% by weight of at least one of the doping elements aluminium, silicon or carbon.

6. Piston ring according to claim 5, **characterised in that** the doping elements of adjacent individual layers (20, 21) are different.

7. Piston ring according to any one of claims 1 to 6, **characterised in that** at least one of the individual layers (20, 21) of the periodicity contains nitrides of at least two metals from the group Ti, Zr, Hf, V, Nb, Ta, Cr, Mo and W, adjacent individual layers (20, 21) differing from each other in terms of at least one metallic element.

8. Piston ring according to claim 7, **characterised in that** at least one individual layer (20, 21) of the periodicity consists of TiZrN, TiAlN, CrSiN, CrZrN, CrTiN or CrVN.

9. Piston ring according to any one of claims 1 to 8, **characterised in that** after one or more periodicities (11) at least one intermediate layer (25) of at least one of the metals Ti, Zr, Hf, V, Nb, Ta, Cr, Mo and W is provided.

10. Piston ring according to any one of claims 1 to 9, **characterised in that** between the carrier material (3) and the wear protection layer (4) at least one adhesive layer (26) is provided.

11. Piston ring according to claim 10, **characterised in that** the adhesive layer (26) consists of at least one of the metals Ti, Zr, Hf, V, Nb, Ta, Cr, Mo and W.

12. Piston ring according to any one of claims 1 to 11, **characterised in that** the thickness of a periodicity (11) is from 30 nm to 1 µm, preferably from 30 nm to 500 nm, in a particularly preferred manner from 30 to 120 nm and in a particularly preferred manner from 60 nm to 120 nm.

13. Piston ring according to any one of claims 1 to 12, **characterised in that** the thickness of an individual layer is preferably from 15 nm to 150 nm.

14. Piston ring according to any one of claims 1 to 13, **characterised in that** the thickness of the multi-layer coating system (10) is from 10 µm to 50 µm, preferably from 10 µm to 30 µm.

15. Use of a piston ring according to claim 1 in diesel engines or Otto engines.

## Revendications

1. Segment de piston (1) réalisé dans un matériau de support (3), en particulier en acier ou en fonte, et présentant un revêtement anti-usure (4) réalisé dans un système multicouche (10) de structure périodique, chaque périodicité (11) étant constituée d'au moins deux couches individuelles (20, 21) en nitrures métalliques, **caractérisé en ce que** des couches individuelles (20, 21) adjacentes à l'intérieur d'une périodicité (11) présentent des éléments métalliques différents et que l'épaisseur d'une couche individuelle (20, 21) est ≥ 15 nm.

2. Segment de piston selon la revendication 1, **caractérisé en ce que** les couches individuelles (20, 21) présentent des nitrures d'au moins un métal choisi dans le groupe formé par Ti, Zr, Hf, V, Nb, Ta, Cr, Mo et W.

3. Segment de piston selon la revendication 1 ou 2, **caractérisé en ce qu'**au moins une couche individuelle (20, 21) de la périodicité (11) est constituée de CrN.

4. Segment de piston selon l'une des revendications 1 à 3, **caractérisé en ce que** chaque périodicité (11) est constituée de deux couches individuelles (20, 21) en CrN et TiN (CrN/TiN), CrN et ZrN (CrN/ZrN) ou CrN et VN (CrN/VN).

5. Segment de piston selon l'une des revendications 1 à 4, **caractérisé en ce qu'**au moins une des couches individuelles (20, 21) de la périodicité contient > 0 à 15 % en poids d'au moins un des éléments de dopage aluminium, silicium ou carbone.

6. Segment de piston selon la revendication 5, **caractérisé en ce que** les éléments de dopage de couches individuelles (20, 21) adjacentes sont différents.

7. Segment de piston selon l'une des revendications 1 à 6, **caractérisé en ce qu'**au moins une des couches individuelles (20, 21) de la périodicité contient des nitrures d'au moins deux métaux choisis dans le groupe formé par Ti, Zr, Hf, V, Nb, Ta, Cr, Mo et W, des couches individuelles (20, 21) adjacentes différant par au moins un élément métallique.

8. Segment de piston selon la revendication 7, **caractérisé en ce qu'**au moins une couche individuelle (20, 21) de la périodicité est constituée de TiZrN, TiAlN, CrSiN, CrZrN, CrTiN ou CrVN.

9. Segment de piston selon l'une des revendications 1 à 8, **caractérisé en ce qu'**après une ou plusieurs périodicités (11), au moins une couche intermédiaire (25) constituée d'au moins un des métaux Ti, Zr, Hf, V, Nb, Ta, Cr, Mo et W est prévue.

10. Segment de piston selon l'une des revendications 1 à 9, **caractérisé en ce qu'**au moins une couche adhésive (26) est prévue entre le matériau de support (3) et la couche anti-usure (4).

11. Segment de piston selon la revendication 10, **caractérisé en ce que** la couche adhésive (26) est constituée d'au moins un des métaux Ti, Zr, Hf, V, Nb, Ta, Cr, Mo et W.

12. Segment de piston selon l'une des revendications 1 à 11, **caractérisé en ce que** l'épaisseur d'une périodicité (11) est de 30 nm jusqu'à 1 µm, de préférence de 30 nm jusqu'à 500 nm, de manière particulièrement préférée de 30 jusqu'à 120 nm et de manière particulièrement préférée de 60 nm jusqu'à 120 nm.

13. Segment de piston selon l'une des revendications 1 à 12, **caractérisé en ce que** l'épaisseur d'une couche individuelle est de préférence de 15 nm à 150 nm.

14. Segment de piston selon l'une des revendications 1 à 13, **caractérisé en ce que** l'épaisseur du système multicouche (10) est de 10 µm à 50 µm, de préférence de 10 µm à 30 µm.

15. Utilisation d'un segment de piston selon la revendication 1 dans des moteurs diesel ou des moteurs à essence.
